# EUROPEAN PATENT APPLICATION

(11) **EP 2 930 765 A1**
(43) Date of publication of application: **14.10.2015**
(21) Application number: 13860913.6
(22) Date of filing: 03.12.2013
(51) Int. Cl.: H01M 2/10, H01M 10/48

(54) **BATTERY PACK DEVICE, METHOD FOR CHECKING BATTERY PACK DEVICE, AND COMPUTER READABLE MEDIUM**

(30) Priority: 04.12.2012 JP 2012265090
(71) Applicant: Kabushiki Kaisha Toshiba, Minato-ku Tokyo 105-8001 (JP)
(72) Inventor: OKABE, Ryo, Tokyo 105-8001 (JP); KOSUGI, Shinichiro, Tokyo 105-8001 (JP); KURODA, Kazuto, Tokyo 105-8001 (JP); MURAKAMI, Manabu, Tokyo 105-8001 (JP)
(74) Representative: Willquist, Sofia Ellinor
(86) International application number: PCT/JP2013/082448
(87) International publication number: WO 2014/087989

(57) **Abstract**

According to an embodiment, a battery pack device includes a plurality of battery modules, a cell detector, and a determiner. Each of the plurality of battery modules stores a plurality of cells. The cell detector detects a cell detection signal representing whether a cell is present or absent at each of a plurality of positions in each battery module. The determiner determines the arrangement state of the cells in each battery module based on the cell detection signal detected by the cell detector, determines the presence/absence of an abnormality from the determined arrangement state of the cells and the connection state of each battery module, and outputs an abnormal signal in case of the abnormality.

## Description

### Technical Field

Embodiments described herein relate generally to a battery pack device, an inspection method of a battery pack device, and a computer-readable storage medium.

### Background Art

Recently, a battery pack using a chargeable secondary battery is used in the power system of an electric motor car, hybrid vehicle, power-assisted bicycle, or the like. The battery pack is also usable in the power facility of a home, hospital, factory, or the like.

The battery pack uses a standardized battery module (predetermined output voltage and capacity) as a minimum constitutional unit, and a plurality of battery modules are connected in series or in parallel in many cases. In each battery module, a predetermined number of plural batteries (cells) are connected in series or in parallel. The method of assembling the battery pack using a battery module as a minimum constitutional unit is employed because convenience in handling and storing the battery modules is taken into consideration.

In the battery pack used in the power facility, the plurality of battery modules are combined in series or in parallel in accordance with the order (necessary capacity or voltage) on the load side. In this case, the output voltage or capacity of the battery pack is an integer multiple of the voltage or capacity of the battery module to be used.

### Citation List

### Patent Literature

Patent Literature 1: Jpn. Pat. Appln. KOKAI Publication No. 2010-80197

### Summary of Invention

### Technical Problem

However, because of recent diversification of loads, the range of the voltage or capacity requested on the load side does not always become an integer multiple of the voltage or capacity of the battery module to be used.

To solve this problem, the combination of cells in the battery module may be changed, and a plurality of types of battery modules having different output voltages or different capacities may be prepared. The plurality of types of battery modules are combined to assemble a battery pack having requested output voltage and capacity.

However, if a battery pack is formed by selectively combining arbitrary battery modules out of a plurality of types of battery modules having different output voltages or capacities, a new problem arises. That is, since the battery modules are identical in terms of appearance, a combination error occurs. A combination error leads to a so-called connection error, resulting in an accident such as an electric shock or breakage by a high current.

It is an object of the embodiment to provide a battery pack device capable of inspecting whether a plurality of battery modules are normally combined, guaranteeing safe use of the battery modules, and meeting the diversification of voltages and capacities requested on the load side, an inspection method of a battery pack device, and a computer-readable storage medium.

### Solution to Problem

According to an embodiment, a battery pack device includes a plurality of battery modules, a cell detector, and a determiner. Each of the plurality of battery modules stores a plurality of cells. The cell detector detects a cell detection signal representing whether a cell is present or absent at each of a plurality of positions in each battery module. The determiner determines the state of a cell in each battery module based on the cell detection signal detected by the cell detector, and outputs an abnormal signal if the determined state of the cell is abnormal.

### Brief Description of Drawings

[FIG. 1A] FIG. 1A is a schematic view showing an example of the arrangement of various kinds of battery modules formed by connecting a plurality of cells.
[FIG. 1B] FIG. 1B is a schematic view showing an example of the arrangement of various kinds of battery modules formed by connecting a plurality of cells.
[FIG. 1C] FIG. 1C is a schematic view showing an example of the arrangement of various kinds of battery modules formed by connecting a plurality of cells.
[FIG. 1D] FIG. 1D is a schematic view showing an example of the arrangement of various kinds of battery modules formed by connecting a plurality of cells.
[FIG. 2A] FIG. 2A is a schematic view showing another example of the arrangement of a battery pack formed by combining a plurality of battery modules.
[FIG. 2B] FIG. 2B is a schematic view showing another example of the arrangement of a battery pack formed by combining a plurality of battery modules.
[FIG. 3] FIG. 3 is a schematic view showing still another example of the arrangement of a battery pack formed by combining a plurality of battery modules.
[FIG. 4A] FIG. 4A is a schematic view showing an example of the arrangement of a battery module inspection system.
[FIG. 4B] FIG. 4B is a schematic view showing an example of the arrangement of a battery module inspection system.
[FIG. 5] FIG. 5 is a schematic view showing an example of the overall block arrangement of the battery module inspection system.
[FIG. 6A] FIG. 6A is a schematic view showing an example of the arrangement of a battery pack formed by correctly combining a plurality of battery modules.
[FIG. 6B] FIG. 6B is a schematic view showing an example of the arrangement of a battery pack formed by erroneously combining a plurality of battery modules.
[FIG. 7] FIG. 7 is a block diagram showing the schematic arrangement of a BMU that collects data via the communication controller of each battery module.
[FIG. 8A] FIG. 8A is a view showing an example of the values of cell absence signals (values different from abnormal values) and cell presence signals (normal values) included in cell detection signals from a battery module.
[FIG. 8B] FIG. 8B is a view showing an example of the values of cell absence signals (values different from abnormal values) and cell presence signals (normal values) included in cell detection signals from a battery module.
[FIG. 9A] FIG. 9A is a view showing another example of the values of cell absence signals (values different from abnormal values) and cell presence signals (normal values) included in cell detection signals from a battery module.
[FIG. 9B] FIG. 9B is a view showing another example of the values of cell absence signals (values different from abnormal values) and cell presence signals (normal values) included in cell detection signals from a battery module.

### Description of Embodiments

The embodiment will now be described with reference to the accompanying drawings. A battery module and a battery pack as the premise of the embodiment will be described first.

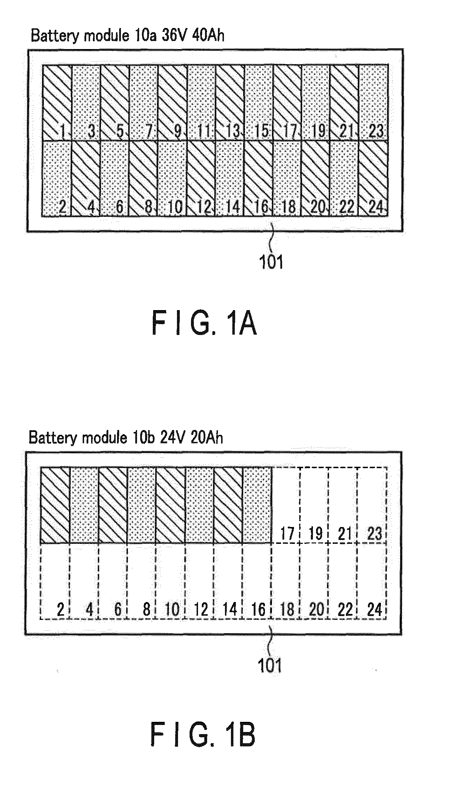

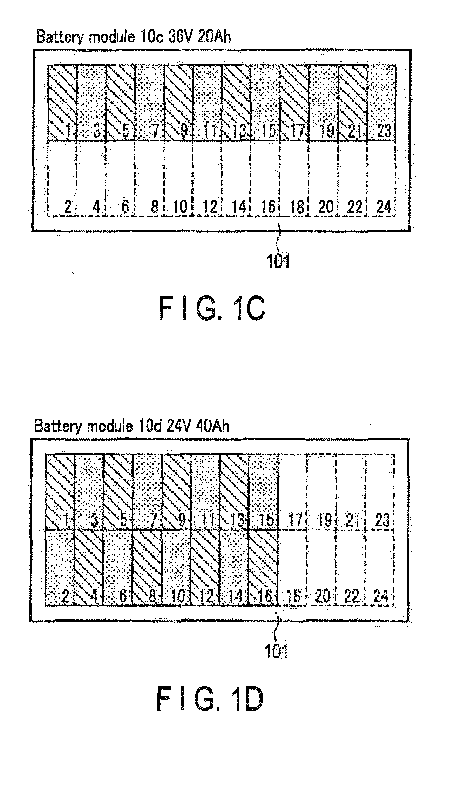

FIGS. 1A, 1B, 1C, and 1D are schematic views respectively showing examples of the arrangements of various kinds of battery modules 10a, 10b, 10c, and 10d each formed by connecting a plurality of cells. In any of the battery modules 10a, 10b, 10c, and 10d, the cells can be arranged at predetermined positions of a case 101 and, for example, 24 cells can be stored at maximum. In the illustrated examples, cell storage position numbers 1 to 24 are added. The arranging method and the numbering method are not limited to these.

When 24 cells are stored, 12 cells are put into one group and connected in series, and two cell groups are arranged in parallel, as shown in FIG. 1A. In the example of FIG. 1A, a first group is formed in which cells at odd-numbered storage positions are connected in series, and a second group is formed in which cells at even-numbered storage positions are connected in series.

In the example of the battery module 10b shown in FIG. 1B, for example, eight cells are connected in series and stored in the case 101. In the example of the battery module 10c shown in FIG. 1C, for example, 12 cells are connected in series and stored in the case 101. In the example of the battery module 10c shown in FIG. 1C, for example, two cell groups each including eight cells connected in series are connected in parallel in the case 101. Note that terminals are provided in the case 101 so as to automatically form a series connection when a plurality of cells are continuously set at the arrangement positions.

Assume that one cell has a voltage of 3 V and a capacity of 20 Ah. In this case, the battery module 10a (type A) has an output (rated) voltage of 36 V and a capacity of 40 Ah, the battery module 10b (type B) has an output (rated) voltage of 24 V and a capacity of 20 Ah, the battery module 10c (type C) has an output (rated) voltage of 36 V and a capacity of 20 Ah, and the battery module 10d (type D) has an output (rated) voltage of 24 V and a capacity of 40 Ah.

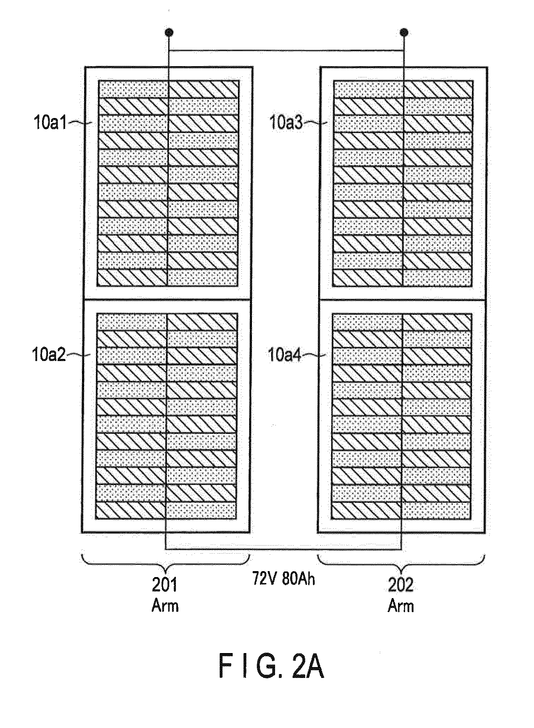

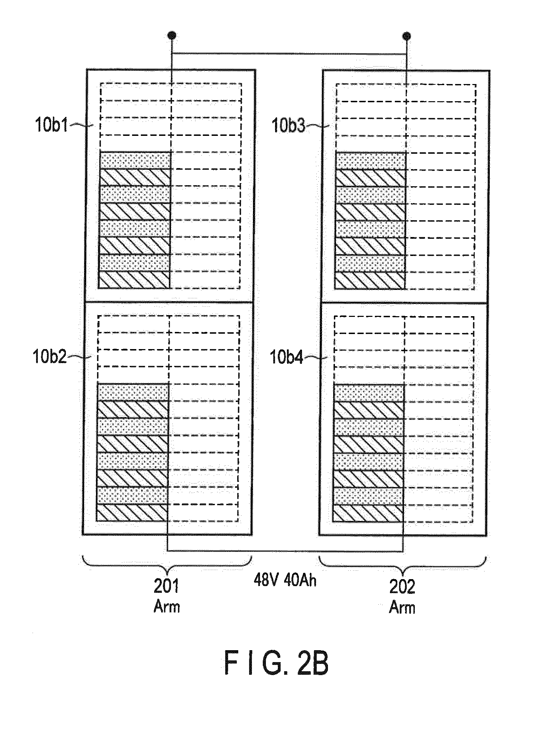

Each of FIGS. 2A and 2B shows a state in which a battery pack is formed by combining a plurality of battery modules. In the battery pack shown in FIG. 2A, battery modules 10a1 to 10a4 of the type A shown in FIG. 1A are combined. An arm 201 is formed by connecting the battery modules 10a1 and 10a2 in series, and an arm 202 is formed by connecting the battery modules 10a3 and 10a4 in series. The two arms 201 and 202 are connected in parallel.

The battery pack shown in FIG. 2B is formed by combining battery modules of the type B shown in FIG. 1B. An arm 201 is formed by connecting the battery modules 10b1 and 10b2 in series, and the arm 202 is formed by connecting the battery modules 10b3 and 10b4 in series. The two arms 201 and 202 are connected in parallel. In the examples of FIGS. 2A and 2B, the battery modules of the same type are combined. FIGS. 2A and 2B illustrate the arms 201 and 202 in a parallel-connected state. At the time of manufacture, after the modules are assembled, a switch (not shown) is turned on, thereby connecting the arms 201 and 202 in parallel.

The battery pack shown in FIG. 2A has a rated voltage of 72 V and a capacity of 80 Ah, and the battery pack shown in FIG. 2B has a rated voltage of 48 V and a capacity of 40 Ah.

In each of the above-described battery packs shown in FIGS. 2A and 2B, the request on the load side permits use of battery modules of the same type.

That is, the battery pack shown in FIG. 2A is requested by the load to have a voltage of 72 V and a capacity of 80 Ah. The voltage and the capacity are integer multiples of the output voltage of 36 V and the capacity of 40 Ah of the battery module of the type A shown in FIG. 1A. In addition, the battery pack shown in FIG. 2B is requested by the load to have a voltage of 48 V and a capacity of 40 Ah. The voltage and the capacity are integer multiples of the output voltage of 24 V and the capacity of 20 Ah of the battery module of the type B shown in FIG. 1B.

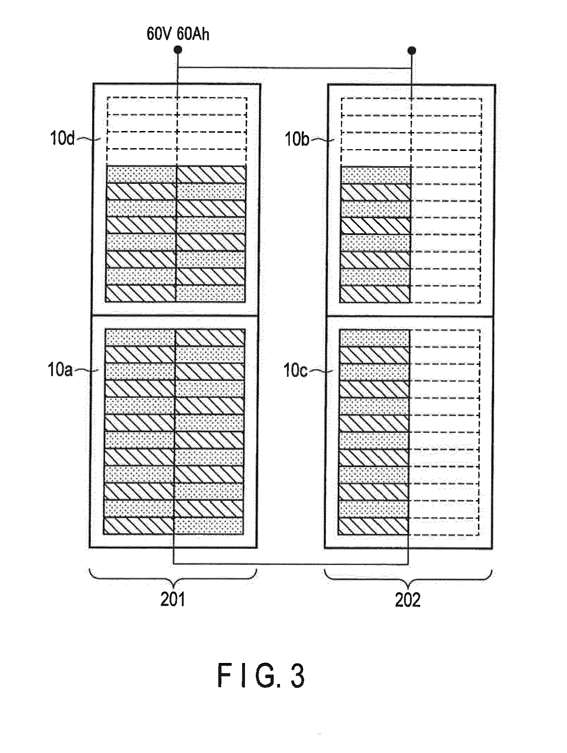

FIG. 3 shows an example in which battery modules are assembled when the battery pack is requested to have 60 V and 60 Ah as rating. In this case, the arm 201 is formed by connecting the battery modules 10a (type A) and 10d (type D) shown in FIGS. 1A and 1D in series, and the arm 202 is formed by connecting the battery modules 10c (type C) and 10b (type B) shown in FIGS. 1C and 1B in series.

In this battery pack, a battery pack having an output voltage (2 V × 20 cells) = 60 V and a capacity (20 Ah × 3 columns) = 60 Ah can be obtained. In the arm 201, the battery modules 10a and 10d have the same capacity of 40 Ah and can therefore be connected in series without any problem. In the arm 202, the battery modules 10c and 10d have the same capacity of 20 Ah and can therefore be connected in series without any problem. The arms 201 and 202 have the same output voltage of 60 V and can therefore be connected in parallel without any problem.

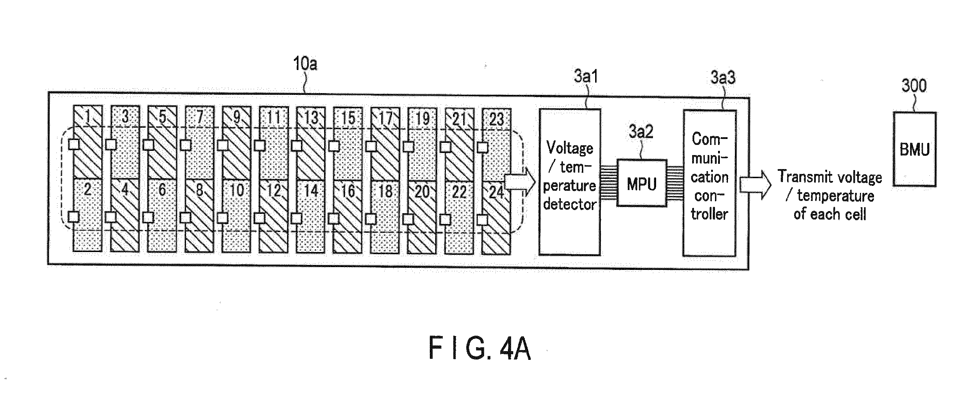

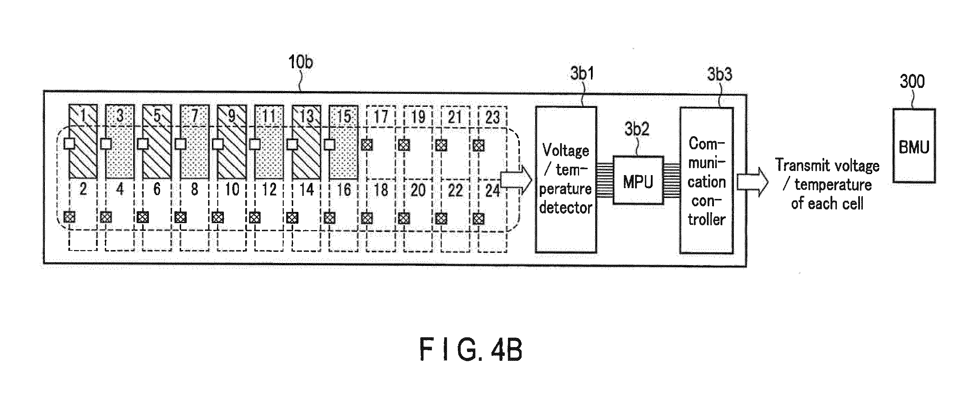

FIGS. 4A and 4B show an example of the arrangement of a battery module inspection system. Each battery module is provided with a management system configured to inspect/manage cells. The management system includes a voltage detector configured to detect the voltage of a cell, a temperature detector configured to detect the temperature of a cell, a processor configured to digitally process signals from these detectors, a non-volatile memory configured to store a program to be executed by the processor, and a communication controller configured to transmit the operation output of the processor to a battery management unit (BMU). The management system also includes an equalizer configured to equalize the voltages of the plurality of cells to almost the same voltage to prevent overcharge or overdischarge of the cells.

FIG. 4A shows a voltage/temperature detector 3a1, a processor 3a2, and a communication controller 3a3 included in the battery module 10a. FIG. 4B shows a voltage/temperature detector 3b1, a processor 3b2, and a communication controller 3b3 included in the battery module 10b. Each of the voltage/temperature detectors 3a1 and 3b1 includes a voltage detector and a temperature detector.

Note that the management system may include a current detector configured to detect the charge/discharge current of the battery module in addition to or in place of the voltage detector configured to detect the voltage of a cell. The voltage/temperature detector may acquire not only a voltage and a temperature but also a current value and other information.

Information from the communication controller 3a3 or 3b3 is sent to one battery management unit (BMU). A BMU 300 can communicate with the communication controller and grasps the state of the entire battery module (that is, the state of the battery pack) based on the information from the communication controller. The BMU 300 detects the connection state of cells, the voltage and temperature of cells, the battery level of cells, abnormal/normal cells, and the output voltage and output current of the battery module, and controls operation stop, activation, charge, discharge, and the like.

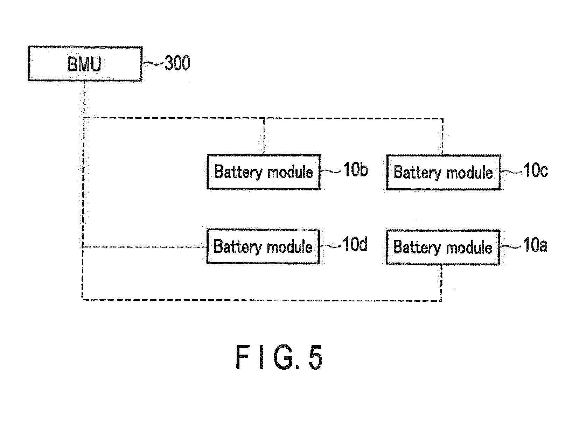

FIG. 5 shows a state in which the communication controllers of the battery modules 10a, 10b, 10c, and 10d shown in FIG. 3 are connected to the BMU.

As described above, when various kinds of battery modules are prepared, a plurality of battery modules selected in accordance with the voltage and capacity requested by the load are assembled to form a battery pack. However, caution is needed not to cause a battery module combination error. A combination error can probably occur at the time of battery pack assembly in the factory, maintenance in a repair site, battery module exchange in case of a failure or the like, and battery module reassembly after inspection conducted by removing the battery module.

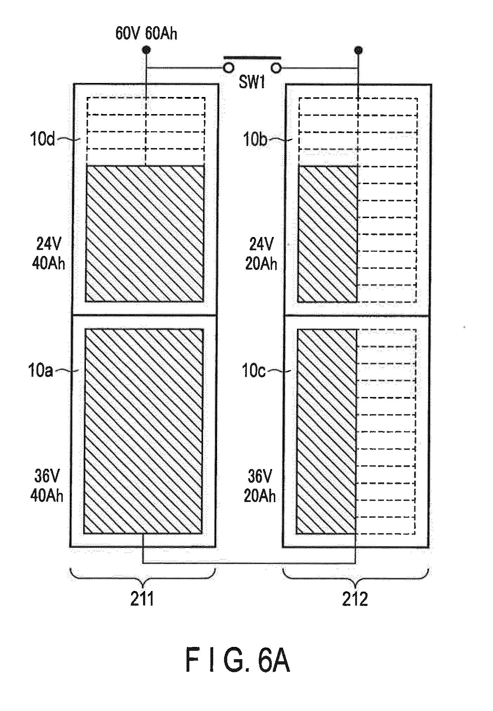

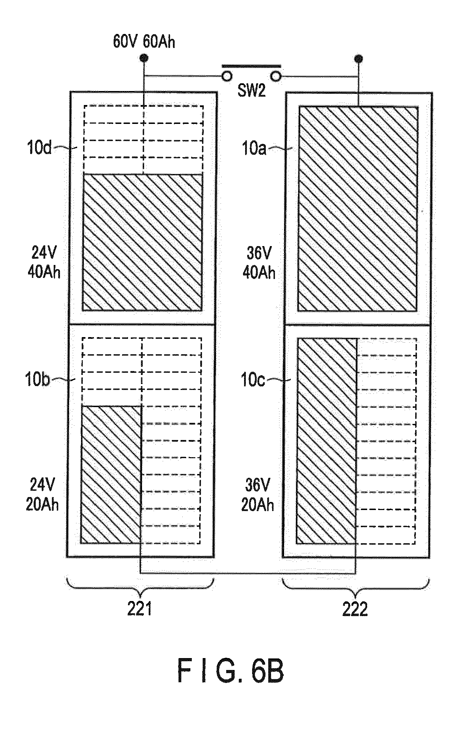

FIG. 6A shows an example in which the battery modules are correctly combined, and FIG. 6B shows an example in which the battery modules are erroneously combined.

Referring to FIG. 6A, in an arm 211, the battery modules 10a (type A) and 10d (type D) are connected in series. In an arm 212, the battery modules 10c (type C) and 10b (type B) are connected in series. In the arm 211 of this battery pack, the total output voltage of the battery modules 10a and 10b is 60 V, and each of the battery modules 10a and 10b has a capacity of 40 Ah. On the other hand, in the arm 212, the total output voltage of the battery modules 10b and 10c is 60 V, and each of the battery modules 10c and 10b has a capacity of 20 Ah. The battery modules having the same capacity can be connected in series without any problem.

Note that a switch SW1 is configured to disconect the arms. At the time of assembly, the switch is turned off. If the combination of battery modules has no problem, the switch SW1 is turned on.

In the battery pack shown in FIG. 6A, when the switch SW1 is turned on, the battery pack has a rated voltage of 60 V and a capacity of 60 Ah.

On the other hand, as shown in FIG. 6B, in an arm 221, the battery modules 10b (type B) and 10d (type D) are connected in series. In an arm 222, the battery modules 10c (type C) and 10a (type A) are connected in series.

In the arm 221 of this battery pack, the total output voltage of the battery modules 10b and 10d is 48 V, the battery module 10b has a capacity of 20 Ah, and the battery module 10d has a capacity of 40 Ah. Hence, the capacities of the battery modules connected in series are different, resulting in mismatching.

In the arm 222, the total output voltage of the battery modules 10c and 10a is 72 V, the battery module 10c has a capacity of 20 Ah, and the battery module 10d has a capacity of 40 Ah. Hence, the capacities of the battery modules connected in series are different, resulting in mismatching. In addition, since the output voltages of the arms 221 and 222 are different, connecting them by a switch SW2 should be avoided, and this mismatching needs to be notified to the user immediately.

As described above, when various kinds of battery modules are prepared, and a plurality of battery modules are assembled in accordance with the voltage and capacity requested by the load, a battery module combination error may occur.

To prevent such an error, this embodiment employs an arrangement and method to be described below in the cell management system.

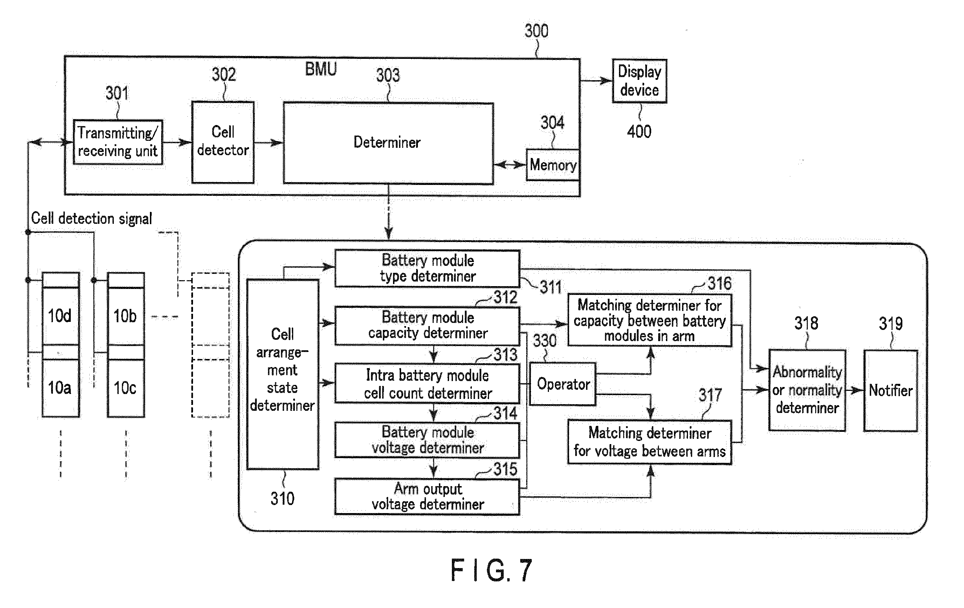

FIG. 7 shows the overall arrangement of a battery pack device 500. In particular, FIG. 7 illustrates details of the functional units of the BMU 300 configured to collect data via the communication controller of each battery module. The BMU 300 is a computer including a processor, a memory, and a data input/output interface. The units of the BMU 300 are functional units implemented by causing the processor to execute a program stored in the memory. The program to be executed by the processor of the BMU 300 is stored in a non-volatile memory such as a memory 304.

Note that in this embodiment, four types of battery modules will be described, and an example of a battery pack formed from the four battery modules will be described for the sake of simplicity. A battery pack incorporated in an actual vehicle, electricity facility, or the like is formed by combining more battery modules in series and parallel.

In each battery module, the processor can detect whether a cell is actually stored at each of the cell storage positions 1 to 24 and obtain a cell detection signal.

A transmitting/receiving unit (can be called a gateway) 301 of the BMU 300 can communicate with the communication controller of each battery module. The transmitting/receiving unit 301 can assign identification data to the communication controller of each battery module and collect data from the communication controller of each battery module by a time division communication method or frequency multiplex method. The transmitting/receiving unit 301 may be a function implemented by the processor by executing the program stored in the memory 304 using the interface to input/output data from/to each battery module.

Hence, cell detection signals from each battery module are received by the transmitting/receiving unit 301 of the BMU 300.

The cell detection signals include a cell presence signal representing that a cell is present and a cell absence signal representing that a cell is absent. The cell absence signal at this time is set to a value different from the value of an abnormal signal. The cell detection signal is input to a cell detector 302 for each cell detection signal of the battery module as a detection target. The cell detector 302 gives the cell presence signal or cell absence signal to a cell arrangement state determiner 310. The cell detector 302 may be a function implemented by the processor by executing the program stored in the memory 304.

FIG. 7 shows various kinds of functions implemented by a determiner 303 of the BMU 300 as individual blocks. The units in the determiner 303 may be implemented by a processor by executing a program stored in a memory. For example, the determiner 303 is formed from a processor that implements various kinds of functions by a program stored in the memory 304.

The cell arrangement state determiner 310 recognizes the cell presence signal or cell absence signal of each of the cell arrangement positions (in this example, the cell arrangement positions 1 to 24 as shown in FIG. 1) and determines the cell arrangement pattern of the inspection target battery module.

If the cell arrangement pattern is known, the following determination is possible. That is, the type of the inspection target battery module can be determined from the cell arrangement pattern. The type of the battery module is determined by a battery module type determiner 311. The battery module type determiner 311 determines whether the actual cell arrangement pattern of each battery module matches a cell arrangement pattern registered in the memory 304 in advance. A matching or mismatching determination output is given to an abnormality or normality determiner 318.

In addition, since the rated voltage and capacity of one used cell are known in advance (this information is stored in, for example, the memory 304), the capacity of the inspection target battery module can be determined using the cell detection signals. The capacity of the battery module is determined by a battery module capacity determiner 312. In addition, the number of cells in the inspection target battery module can be determined. The number of cells in the battery module is determined by an intra battery module cell count determiner 313. Furthermore, the output voltage of the inspection target battery module can be determined. The output voltage of the battery module is determined by a battery module voltage determiner 314. Also, the voltage of an arm formed by the inspection target battery module can be determined. The output voltage of the arm is determined by an arm output voltage determiner 315.

When the capacity of each battery module is known, matching of the capacity between the battery modules in each arm can be determined. This determination is done by a matching determiner 316 for the capacity between the battery modules in an arm. When the output voltage of each battery module is known, matching of the voltage between the arms can be determined. This determination is done by a matching determiner 317 for the voltage between the arms.

In the above-described determination processing, an operator 330 also cooperatively performs addition processing of the number of cells, voltage, capacity, and the like. During the determination processing, the switches SW1 and SW2 shown in FIGS. 6A and 6B are off.

The type determination output from the battery module type determiner 311 and the matching or mismatching determination outputs from the matching determiner 316 for the capacity between the battery modules in an arm and the matching determiner 317 for the voltage between the arms are given to the abnormality or normality determiner (abnormality determiner) 318. In accordance with the type determination output and the matching or mismatching determination outputs, the abnormality or normality determiner 318 decides one of abnormality and normality and gives the decided result to a notifier 319. The notifier 319 gives the abnormal or normal signal of the battery module to, for example, a display device 400 and provides it to the user.

The above-described arrangement includes a plurality of embodiments. The first embodiment is directed to a means and method for determining a battery module type and thus determining whether a battery pack is normally assembled.

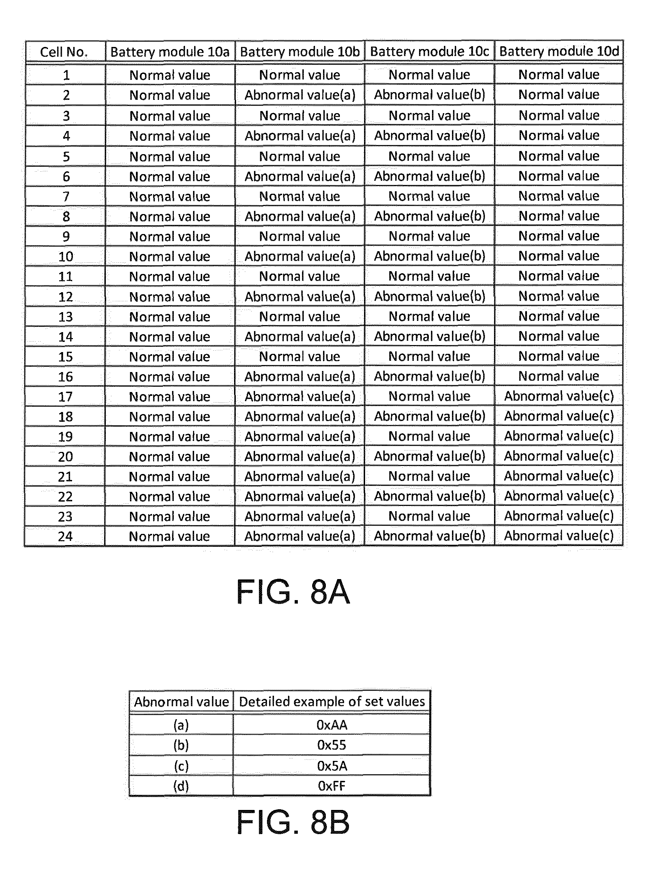

In this case, as for the cell detection signals from the battery modules, for example, the abnormal value (the value of a cell absence signal) set to the cell absence signal changes between the battery modules, as shown in FIGS. 8A and 8B. In this example, for example, the following rule is defined, that is, different values are assigned to the cell absence signals of the battery modules. For example, ( 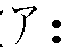 value 0xAA) is assigned to the absence signal output when the absence of a battery is detected in the battery module 10b (type B). ( 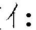 value 0x55) is assigned to the absence signal output when the absence of a battery is detected in the battery module 10c (type C). ( 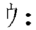 value 0x5A) is assigned to the absence signal output when the absence of a battery is detected in the battery module 10d (type D).

The above assignment is done in a mode to detect the absence of cells and the presence of cells. If an abnormality is detected in cell voltage equalizing processing, a voltage measurement mode, or a temperature measurement mode, an abnormal signal ( 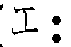 value 0xFF) is assigned.

As described above, when the cell absence signal is detected in each battery module, the type of each battery module can be determined based on a pattern signal representing the absence of cells and the presence of cells. Patterns representing the plurality of types of battery modules to be used may be registered in the memory 304 in advance.

As a result, when the presence of a battery module cell arrangement pattern of a type that is not registered in advance is discriminated from the cell arrangement pattern determined from the cell detection signal, the battery module type determiner 311 determines that the current battery pack is abnormal.

Note that in the normal use mode of the battery pack, if an abnormality is determined from the measured voltage or temperature measurement value of a cell, an abnormal signal ( 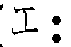 value 0xFF) is transmitted. The BMU 300 never confuses the operation of determining the absence of cells and the presence of cells with another operation.

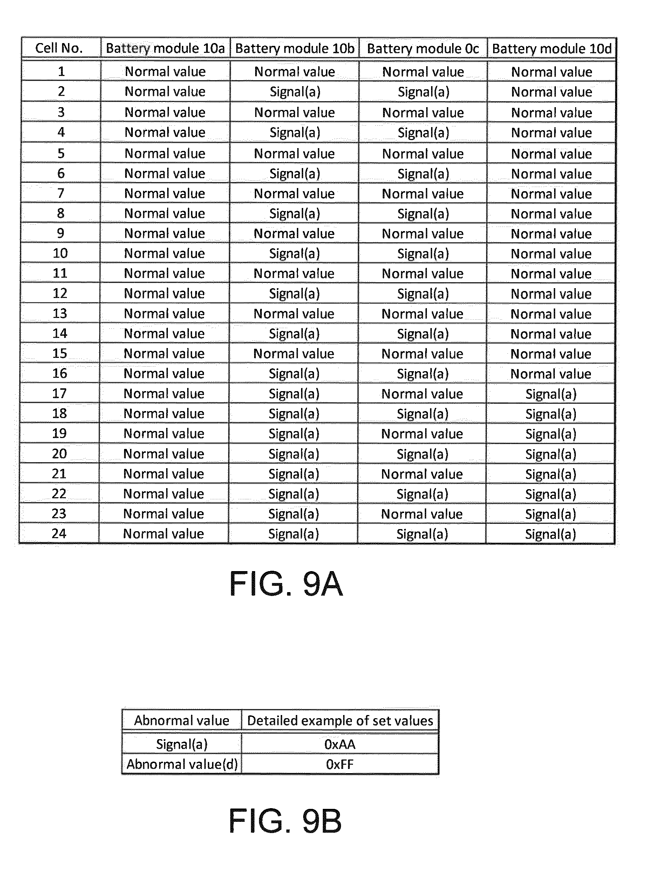

The above-described arrangement also includes the following embodiment. That is, as for the cell detection signals from the battery modules, for example, a value (7: 0xAA is set to the cell absence signal, as shown in FIGS. 9A and 9B. This value is different from the abnormal signal ( 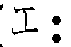 value 0xFF) used for abnormality determination in the normal use mode of the battery pack.

When this rule is employed, the number of present cells and the number of absent cells in each battery module can be grasped.

The absence of cells and the presence of cells in each battery module are determined by the cell arrangement state determiner 310. The battery module capacity determiner 312 determines the capacity of each battery module. The intra battery module cell count determiner 313 determines the number of cells in each battery module. The battery module voltage determiner 314 determines the output voltage of each battery module. The arm output voltage determiner 315 determines the output voltage of each arm. The matching determiner 316 for the capacity between the battery modules in an arm determines matching of the capacity between the battery modules in each arm. The matching determiner 317 for the voltage between the arms determines matching of the voltage between the arms.

The determination methods will be described below in more detail.
(Determination 1) When the number of cells connected in series in each battery module is known, the total number of cells controlled by the BMU 300 is known. (Total number of cells controlled by BMU 300) ÷ number of parallel battery modules × cell voltage = rated voltage is thus calculated. It is determined whether the result matches (fits) a desired rated voltage.
(Determination 2) To check the voltage in the parallel direction of arms, it is determined whether the numbers of cells in the series direction of the arms match (fit) in all the parallel arms.
(Determination 3) Check on an arm basis: it is determined whether the capacities of all the battery modules in each arm match (fit).

The above-described determinations will be described with reference to the example shown in FIG. 6A in which the battery modules are correctly combined and the example shown in FIG. 6B in which the battery modules are erroneously combined.

In Case of FIG. 6A:
(Determination 1) (Total number of cells controlled by BMU 300) 60 ÷ number of parallel battery modules 2 × cell voltage 3 = rated voltage 60 ...(fit)
(Determination 2) Number of cells in series direction of arm 211: 20, number of cells in series direction of arm 212: 20 ... (fit)
(Determination 3) In the arm 211, capacity of battery module 10a: 40 Ah, capacity of battery module 10d: 40 Ah ... (fit), and in the arm 212, capacity of battery module 10c: 20 Ah, capacity of battery module 10b: 20 Ah ...(fit)

As described above, in the case of FIG. 6A, all determinations 1 to 3 result in (fit), activation is permitted.

In Case of FIG. 6B:
(Determination 1) (Total number of cells controlled by BMU 201) 60 ÷ number of parallel battery modules 2 × cell voltage 3 = rated voltage 60 ...(fit)
(Determination 2) Number of cells in series direction of arm 221: 16, number of cells in series direction of arm 222: 24 ... (unfit)
(Determination 3) In the arm 221, capacity of battery module 10d: 40 Ah, capacity of battery module 10d: 20 Ah ... (unfit), and in the arm 222, capacity of battery module 10c: 40 Ah, capacity of battery module 10a: 20 Ah ... (unfit)

As described above, in the combination of FIG. 6B, since at least one of determinations 1 to 3 results in (unfit), activation is not permitted.

The present invention holds even when only determining the type of each battery module as the first embodiment. That is, if an unfitted (unregistered) battery module exists, the user may be notified that the battery pack is abnormal. The user can thus reexamine the battery pack. As the second embodiment, fit/unfit of a battery pack may be determined by determining the rated voltage, the voltage of each arm, and the capacity of each battery module in each arm using the table described with reference to FIG. 9.

Furthermore, as the third embodiment, the above-described first and second embodiments may be combined. That is, the type of each battery module is determined using the table described with reference to FIG. 8. Next, fit/unfit is determined by determining the rated voltage, the voltage of each arm, and the capacity of each battery module in each arm using the table described with reference to FIG. 9. According to this embodiment, it is possible to more correctly grasp the state of the battery pack.

According to another aspect of the embodiment of the present invention, it is possible to provide a battery module inspection method characterized by in a predetermined inspection mode, setting error information to a unique value in advance for each battery module type by the processor of the battery module, and causing the battery module to transmit the error information to the BMU, thereby determining the type of the battery module. Here, the BMU internally stores the type of the battery module and the arrangement pattern of battery cells in advance.

In a case where each battery module is diagnosed for maintenance of a cell voltage or cell temperature, if the determiner detects an abnormality of a cell, an abnormal signal of an abnormal value discriminated from the error information can be transmitted.

The present invention is not limited to the above embodiments, and the names of the blocks are not limited to those shown in the drawings as long as they perform equivalent operations. The embodiments also incorporate integrated blocks or divided blocks. The BMU 300 may be provided with circuit boards respectively dedicated to the blocks. Alternatively, the blocks may be implemented by software (program).

While certain embodiments of the inventions have been described, these embodiments have been presented by way of examples only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The appended claims and their equivalents are intended to cover such forms or modifications as would fall within the scope and spirit of the inventions.

## Claims

1. A battery pack device including a plurality of battery modules each storing a plurality of cells, comprising:
a cell detector configured to detect a cell detection signal representing whether a cell is present or absent at each of a plurality of positions in each battery module; and
a determiner configured to determine an arrangement state of the cells in each battery module based on the cell detection signal detected by the cell detector and determine presence/absence of an abnormality from the arrangement state of the cells in each battery module and a connection state of each battery module.

2. The battery pack device according to claim 1, wherein the determiner comprises:
a type determiner configured to determine a type of each battery module based on a pattern of a cell absence signal representing the absence of a cell and set to a value different from a cell abnormal signal representing the abnormality of the cell out of the cell detection signal; and
an abnormality determiner configured to output the abnormal signal if the type determiner determines that the type of the battery module is abnormal.

3. The battery pack device according to claim 1, wherein the determiner comprises:
a first matching determiner configured to determine the number of cells connected in parallel in each battery module based on the cell detection signal detected by the cell detector and determine whether capacities match or mismatch between the battery modules in arms formed from series-connected battery modules out of the plurality of battery modules;
a second matching determiner configured to determine, from the number of cells in each battery module and the number of cells in a series direction of each arm determined based on the cell detection signal, whether voltages match or mismatch between the plurality of arms; and
an abnormality determiner configured to output the abnormal signal if one of the first matching determiner and the second matching determiner determines mismatching.

4. The battery pack device according to claim 1, wherein the determiner comprises:
a type determiner configured to determine a type of each battery module based on a pattern of a cell absence signal representing the absence of a cell and set to a value different from a cell abnormal signal representing the abnormality of the cell out of the cell detection signal in a first mode;
a first matching determiner configured to determine the number of cells connected in parallel in each battery module based on the cell detection signal and determine whether capacities match or mismatch between the battery modules in arms formed from series-connected battery modules out of the plurality of battery modules in a second mode;
a second matching determiner configured to determine, from the number of cells in each battery module and the number of cells in a series direction of each arm based on the cell detection signal, whether voltages match or mismatch between the plurality of arms in the second mode; and
an abnormality determiner configured to output the abnormal signal if the type determiner determines in the first mode that the type of the battery module is abnormal or if one of the first matching determiner and the second matching determiner determines mismatching in the second mode.

5. The battery pack device according to any one of claims 1, 2, 3, and 4, wherein the cell abnormal signal having the value different from the cell absence signal is a signal of an abnormal value output from the battery module when diagnosed for maintenance of one of a voltage and temperature of the cell.

6. An inspection method of a battery pack device including a plurality of battery modules each storing a plurality of cells, comprising:
detecting a cell detection signal representing whether a cell is present or absent at each of a plurality of positions in each battery module;
determining an arrangement state of the cells in each battery module based on the detected cell detection signal; and
determining presence/absence of an abnormality from the arrangement state of the cells in each battery module and a connection state of each battery module.

7. The inspection method of the battery pack device according to claim 6, further comprising:
determining a type of each battery module based on a pattern of a cell absence signal representing the absence of a cell and set to a value different from a cell abnormal signal representing the abnormality of the cell out of the cell detection signal; and
outputting the abnormal signal representing the abnormality if it is determined in the determining the type that the type of the battery module is abnormal.

8. The inspection method of the battery pack device according to claim 6, further comprising:
determining the number of cells connected in parallel in each battery module based on the cell detection signal and determining whether capacities match or mismatch between the battery modules in arms formed from series-connected battery modules out of the plurality of battery modules;
determining, from the number of cells in each battery module and the number of cells in a series direction of each arm determined based on the cell detection signal, whether voltages match or mismatch between the plurality of arms; and
outputting the abnormal signal representing the abnormality if one of mismatching of the capacities between the battery modules in the arms and mismatching of the voltages between the plurality of arms is determined.

9. The inspection method of the battery pack device according to claim 6, further comprising:
determining a type of each battery module based on a pattern of a cell absence signal representing the absence of a cell and set to a value different from a cell abnormal signal representing the abnormality of the cell out of the cell detection signal in a first mode;
determining the number of cells connected in parallel in each battery module based on the cell detection signal and determining whether capacities match or mismatch between the battery modules in arms formed from series-connected battery modules out of the plurality of battery modules in a second mode;
determining, from the number of cells in each battery module and the number of cells in a series direction of each arm based on the cell detection signal, whether voltages match or mismatch between the plurality of arms in the second mode; and
outputting the abnormal signal representing the abnormality if it is determined in the first mode that the type of the battery module is abnormal or if mismatching of the capacities between the battery modules in the arms is determined or mismatching of the voltages between the plurality of arms is determined in the second mode.

10. A computer-readable storage medium storing an inspection program used for a battery pack device including a plurality of battery modules each storing a plurality of cells,
the inspection program causing a computer to:
detect a cell detection signal representing whether a cell is present or absent at each of a plurality of positions in each battery module;
determine an arrangement state of the cells in each battery module based on the detected cell detection signal; and
determine presence/absence of an abnormality from the arrangement state of the cells in each battery module and a connection state of each battery module.

11. The computer-readable storage medium according to claim 10, wherein the inspection program further causes the computer to:
determine a type of each battery module based on a pattern of a cell absence signal representing the absence of a cell and set to a value different from a cell abnormal signal representing the abnormality of the cell out of the cell detection signal; and
output the abnormal signal representing the abnormality if it is determined in the determining the type that the type of the battery module is abnormal.

12. The computer-readable storage medium according to claim 10, wherein the inspection program further causes the computer to:
determine the number of cells connected in parallel in each battery module based on the cell detection signal and determine whether capacities match or mismatch between the battery modules in arms formed from series-connected battery modules out of the plurality of battery modules;
determine, from the number of cells in each battery module and the number of cells in a series direction of each arm determined based on the cell detection signal, whether voltages match or mismatch between the plurality of arms; and
output the abnormal signal representing the abnormality if mismatching of the capacities between the battery modules in the arms is determined or if mismatching of the voltages between the plurality of arms is determined.

13. The computer-readable storage medium according to claim 10, wherein the inspection program further causes the computer to:
determine a type of each battery module in a first mode;
determine the number of cells connected in parallel in each battery module based on the cell detection signal and determine whether capacities match or mismatch between the battery modules in arms formed from series-connected battery modules out of the plurality of battery modules in a second mode;
determine, from the number of cells in each battery module and the number of cells in a series direction of each arm based on the cell detection signal, whether voltages match or mismatch between the plurality of arms in the second mode; and
output the abnormal signal representing the abnormality if it is determined that the type of the battery module is abnormal, if mismatching of the capacities between the battery modules in the arms is determined, or if mismatching of the voltages between the plurality of arms is determined.
